# EUROPEAN PATENT SPECIFICATION

(11) **EP 3 209 102 B1**
(45) Date of publication and mention of the grant of the patent: **16.11.2022**
(21) Application number: 15851522.1
(22) Date of filing: 10.06.2015
(51) Int. Cl.: H05K 7/20

(54) **COMMUNICATION SYSTEM AND COMMUNICATION DEVICE THEREFOR**
KOMMUNIKATIONSSYSTEM UND KOMMUNIKATIONSVORRICHTUNG DAFÜR
SYSTÈME DE COMMUNICATION ET DISPOSITIF DE COMMUNICATION ASSOCIÉ

(30) Priority: 17.10.2014 CN 201410555066
(43) Date of publication of application: 23.08.2017
(73) Proprietor: ZTE Corporation, Shenzhen, Guangdong 518057 (CN)
(72) Inventor: YANG, Zhengdong, Shenzhen Guangdong 518057 (CN); LI, Jitao, Shenzhen Guangdong 518057 (CN); ZHANG, Minhua, Shenzhen Guangdong 518057 (CN); TANG, Yi, Shenzhen Guangdong 518057 (CN); FAN, Kun, Shenzhen Guangdong 518057 (CN)
(74) Representative: GLP S.R.L.
(86) International application number: PCT/CN2015/081196
(87) International publication number: WO 2016/058396

(56) References cited:
- EP-A1- 2 510 764
- EP-B1- 2 510 764
- CN-A- 102 465 766
- CN-A- 103 338 613
- CN-Y- 201 115 248
- CN-Y- 201 134 983
- JP-A- H07 106 782
- JP-A- 2013 243 228
- US-A1- 2007 115 643
- US-A1- 2011 194 255
- US-A1- 2012 123 664
- US-B1- 6 518 868

## Description

### TECHNICAL FIELD

The present disclosure relates to the field of communication, and more particularly, to a communication system and a communication apparatus thereof.

### BACKGROUND

The communication apparatus has a printed circuit board (referred to as PCB) and a variety of electronic devices therein, and thus has certain power consumption. Few of the power consumption of the variety of electronic devices is output via signal cables, while most of the power consumption converts into heat energy, which makes temperatures of the devices and the PCB rise. Therefore, it is necessary to perform a heat dissipation design for the communication apparatus so that the heat generated by the communication apparatus can be smoothly discharged to the outside of the apparatus.

The means for dissipating heat by the communication apparatus may be divided into natural heat dissipation and forced air cooling. In the forced air cooling, the heat of the devices is brought out of the communication apparatus by driving air to flow through a heating element via a fan. The natural heat dissipation does not use a fan for active heat dissipation, and is a passive heat dissipation manner. In the natural heat dissipation, the heating components transfer their heat to a radiator by installing the radiator or other methods, the radiator has a large heat dissipation surface area, and the heat is spread to the surface of the radiator, and then is conducted to the neighboring air. The change of air temperature generates a density change, thereby a natural convection is generated under the action of gravity. In another embodiment, the components and the radiator radiate a certain amount of infrared heat to the outside, and a portion of the heat is transferred to the outside by this radiation in the form of electromagnetic waves.

Both the natural heat dissipation and the forced air cooling have some advantages and disadvantages. The forced air cooling is adaptable for apparatuses having large power consumption, that is, the situations which cannot be solved by the natural heat dissipation. However, since the forced air cooling needs to install a fan, when the fan rotates, the reliability issues, such as noise, dust, fan failure and the like, are also brought about. For the conditions in which the power consumption density is between the natural heat dissipation and forced air cooling, that is, there is a certain degree of difficulty to use the conventional natural heat dissipation manner to dissipate heat, and it is unwanted to install a fan to introduce other problems, if the insufficient heat dissipation capability in the related art may be solved by using some means for strengthening the natural heat dissipation, then not only the heat dissipation problem is solved, but also drawbacks brought about by the use of the forced air cooling are avoided.

For small box-type communication apparatuses, a large part thereof adopts the conventional natural heat dissipation manner, that is, the PCB is installed in a housing of the communication apparatus through a traditional stud or bolt, or through a PCB slide, and heating elements on the PCB radiate heat through an installed radiator. The heat dissipation capacity of this heat dissipation method is limited. The radiator is installed in the housing of the apparatus. Even for a punched metal housing, there are some differences between the air temperatures inside and outside the housing. That is, the radiator is not in direct touch with the air outside the housing. In another embodiment, for some package-type devices, such as a Quad Flat No-Lead Package (referred to as QFN), a TO and other packages, the characteristic of the package is that the internal heat is conducted to the PCB preferentially. However, a thermal resistance to an upper surface is much larger than a thermal resistance to the PCB. Therefore, it is not the best way to install a radiator on the upper surface of the chip. How to spread the heat to the PCB and then efficiently discharge it out of the PCB is essential for heat dissipation of the apparatus.

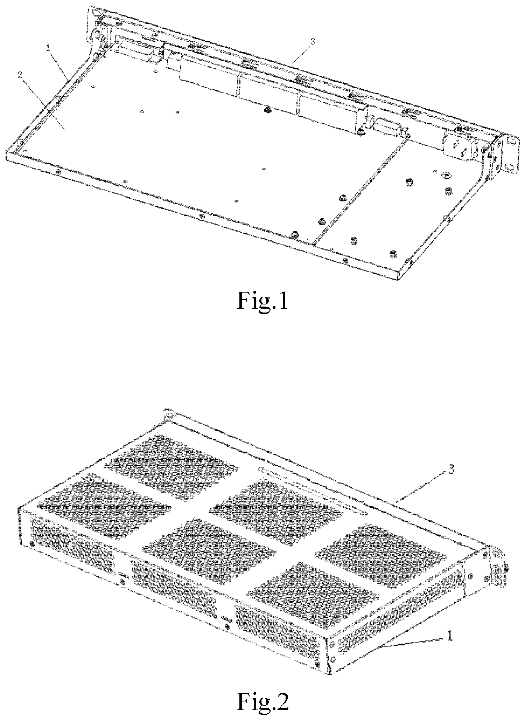

Figs. 1 and 2 are simple explanations of a small box-type communication apparatus 3 in the related art. A plurality of protruding riveted nuts are provided on a bottom case 1 of the apparatus, and mounting screw holes are arranged at corresponding positions on the PCB board 2. The PCB board 2 is supported by the protruding riveted nuts and thereby is fixed by mounting screws to the bottom case of the apparatus. The devices on the PCB board may be cooled naturally by an additionally installed radiator.

The related art is characterized by the fact that the PCB board 2 is in point contact with the bottom case 1 of the apparatus, that is, only the screw holes are in contact with the riveted nuts of the bottom case 1 of the apparatus, and the rest of the PCB board 2 is suspended over the bottom case of the apparatus. This leads to a drawback that the heat of the PCB board 2 cannot be effectively conducted and diffused, and can only be naturally cooled through its own limited area.

For the above-mentioned condition in which the heat is preferentially conducted to the device package of the PCB assembly, a number of such devices may cause heat aggregation on the PCB board, which is not conducive to the heat dissipation of such packages themselves, and also affects a local temperature environment of the PCB board at which other temperature sensitive devices, such as a crystal oscillator, are located.

This section provides background information related to the present disclosure which is not necessarily prior art.

Patent document EP2510764 discloses a set-top box having microperforations.

Patent document US2011/0194255 discloses an electronic component unit and manufacturing method thereof.

Patent document US2012/0123664 discloses an electronic digital governor and method of assembly.

Patent document US2007/0115643 discloses an electronic device with dual heat dissipating structures.

Patent document JP407106782 discloses a cooling structure in an electronic equipment.

Patent application document JP2013243228 A discloses an electronic circuit device which efficiently radiates heat generated by an electronic component involving heat generation to the exterior of the device.

### SUMMARY

It is a primary object of the present disclosure to provide a communication system and a communication apparatus thereof to solve the problem in the related art that the heat dissipation capability of the communication apparatus is poor.

In order to achieve the above object, according to an embodiment of the present disclosure, there are provided a communication apparatus and a communication system including the communication apparatus, as defined in the annexed claims.

According to the technical solution of the present disclosure, the communication apparatus of the present disclosure connects an edge of the printed circuit board with the bottom case through the heat-conductive mounting strip, so that the point contact of the printed circuit board with the bottom case in the related art becomes a surface contact, thus improving a path for conducting and diffusing heat from the printed circuit board to the bottom case, and improving the heat dissipation capacity of the communication apparatus.

### BRIEF DESCRIPTION OF THE DRAWINGS

The accompanying drawings, which are incorporated in and constitute a part of this application, are intended to provide a further understanding of the disclosure, and illustrative embodiments of the disclosure and its description are intended to be illustrative of the disclosure and are not to be construed as limiting the invention which is defined by the appended claims . In the drawings:
Fig. 1 shows a schematic diagram of an internal structure of a communication apparatus in the related art;
Fig. 2 shows a schematic diagram of an external structure of the communication apparatus in the related art;
Fig. 3 shows a schematic diagram of an internal structure of a communication apparatus in the present disclosure;
Fig. 4 shows a schematic diagram of a bottom structure of the printed circuit board assembly in Fig. 3;
Fig. 5 shows a schematic diagram of a structure of the printed circuit board assembly in Fig. 3;
Fig. 6 shows a front view of Fig. 5;
Fig. 7 shows a schematic diagram of a structure of the printed circuit board laid with a heat conductive layer;
Fig. 8 shows a schematic diagram of a structure having a first heat dissipation via hole in Fig. 7; and
Fig. 9 shows a schematic diagram of a structure of a ground layer copper sheet of the printed circuit board.

The above drawings include the following reference numerals:
1. bottom case; 2. PCB board; 3. communication apparatus; 10. bottom case; 20. printed circuit board; 21. recess; 22. heat conductive layer; 23. ground layer copper sheet; 24. first heat dissipation via hole; 25. second heat dissipation via hole; 30. heat-conductive mounting strip; 31. support portion; 32. connecting portion; 40. radiator.

### DETAILED DESCRIPTION

It is to be noted that without conflict, the embodiments and features in the embodiments of the present application may be combined with each other. Hereinafter, the present disclosure will be described in detail with reference to the accompanying drawings and the embodiments. Obviously, the described embodiments are merely part of the embodiments of present disclosure, but not all embodiments. All embodiments according to the invention are defined by the appended claims.

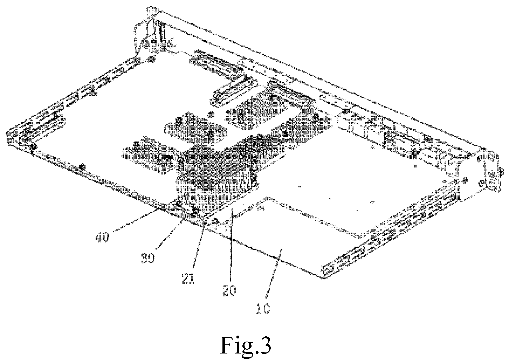

According to an embodiment of the present disclosure, there is provided a communication apparatus. Referring to Figs. 3 to 9, the communication apparatus includes: a bottom case 10 and a printed circuit board 20 mounted on the bottom case 10. The communication apparatus further includes a heat-conductive mounting strip 30. The printed circuit board 20 is mounted on the bottom case 10 by the heat-conductive mounting strip 30. A lower end surface of the heat-conductive mounting strip 30 is connected to the bottom case 10, and an upper end surface of the heat-conductive mounting strip 30 is connected to the printed circuit board 20. As can be seen from the above technical solution, the communication apparatus of the present disclosure connects an edge of the printed circuit board 20 with the bottom case 10 through the heat-conductive mounting strip 30, so that the point contact between the printed circuit board 20 and the bottom case 10 in the related art becomes a surface contact, the path for transferring and spreading heat from the printed circuit board 20 to the bottom case 10 is improved, and the heat dissipation capacity of the communication apparatus is improved.

In the embodiments of the present disclosure, the printed circuit board 20 is provided with a recess 21. The heat-conductive mounting strip 30 includes a support portion 31 and a connecting portion 32. The printed circuit board 20 is supported on the support portion 31, and the connecting portion 32 passes through the recess 21 and then is connected to a radiator 40 on the printed circuit board 20.

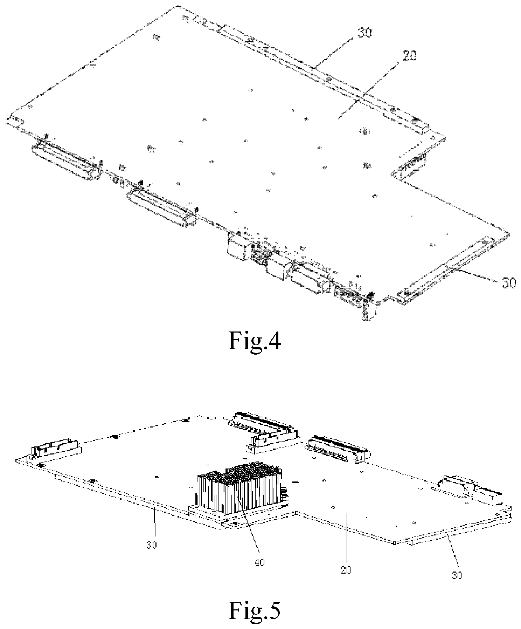

In the present application, on the basis of the foregoing embodiments, the heat-conductive mounting strip 30 provides an additional contact heat conduction for the radiator 40 on a top surface of the board while providing a surface touch between a bottom surface at an edge of the printed circuit board 20 and the bottom case 10 of the apparatus. As shown in Fig. 5, the entire radiator 40 of the component on the top surface of the printed circuit board 20 or a substrate of the radiator 40 may be extended to the edge of the board until it may cover the edge of the printed circuit board 20 and the heat-conductive mounting strip 30. Meanwhile, a corresponding notch or window (recess 21) is designed at this position on the printed circuit board 20 so that the heat-conductive mounting strip 30 extends upwardly through the notch to the top surface of the printed circuit board and then contacts the bottom surface of the substrate of the radiator 40.

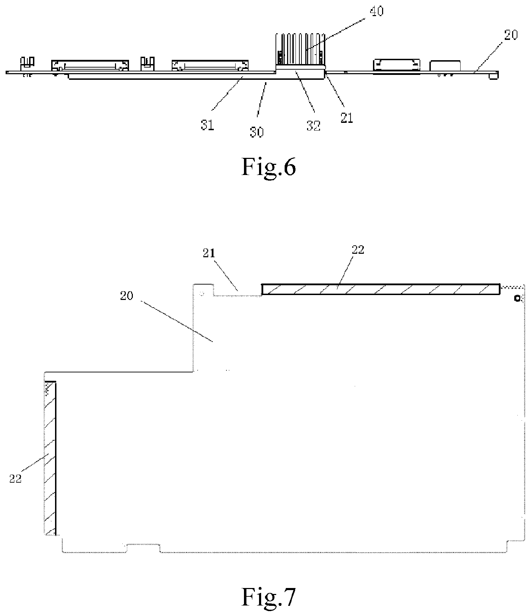

The relative relationships between the radiator 40 and the heat-conductive mounting strip 30 and the printed circuit board 20 is more clearly shown in Fig. 6. In this embodiment, the heat-conductive mounting strip 30 not only provides the surface contact with the bottom case 10 for the printed circuit board 20, but also provides the radiator 40 with the surface contact to the bottom case 10, so that the printed circuit board 20 can be provided with a good heat dissipation channel, and the heat dissipation of specific devices is strengthened.

On the basis of this, for some of the components which are mainly cooled by the radiator 40, such as BGA packages, the heat-conductive mounting strip 30 is extended to the other side of the printed circuit board and touches the radiator 40 by opening a window or notch (recess 21) at the corresponding position of the printed circuit board, so as to enhance the heat dissipation of the radiator 40. In this way, the problem of lacking the outwardly conductive path of the printed circuit board 20 in the related art has been solved, and the heat dissipation capacity of the device radiator 40 in the related art has been improved.

In the embodiments of the present disclosure, the heat-conductive mounting strip 30, the printed circuit board 20, and the bottom case 10 are coated with a heat-conductive filler material on their touch surfaces. The roughness of respective touch surfaces of the heat-conductive mounting strip 30, the printed circuit board 20, and the bottom case 10 is relatively large. After being coated with the heat-conductive filler material, the smoothness of the respective contact surfaces can be improved, and the heat conduction performance of individual components is improved.

In the embodiments of the present disclosure, the heat-conductive filler material is a heat-conductive silicone grease. According to the actual situation, other materials may be used as the heat-conductive filler material.

In the embodiments of the present disclosure, the heat-conductive mounting strip 30 and the printed circuit board 20 are connected to the bottom case 10 by screws. In this way, the fastening performance between the heat-conductive mounting strip 30 and the printed circuit board 20 and the bottom case 10 can be improved.

In the embodiments of the present disclosure, the communication apparatus includes a plurality of heat-conductive mounting strips 30, and the plurality of heat-conductive mounting strips 30 are provided in a circumferential direction of the printed circuit board 20. Fig. 4 shows a relative relationship between the heat-conductive mounting strip 30 and the printed circuit board 20 according to the embodiment of the present disclosure. The heat-conductive mounting strip 30 is mounted on an edge area of the printed circuit board 20, and a length, a width, and a number of the heat-conductive mounting strip 30 may be flexibly arranged according to an actual device distribution of the printed circuit board 20 and a distribution condition of the ground layer copper sheet 23. In this way, the heat dissipation of the printed circuit board 20 can be improved.

In the embodiments of the present disclosure, the printed circuit board 20 includes a device arranging area and a device prohibition area provided around the device arranging area, and the heat-conductive mounting strip 30 is connected to the device prohibition area of the printed circuit board 20. In general, the edge of the printed circuit board 20 is the device prohibition area. On the edge area of the printed circuit board 20, a plane to be in surface contact with other structure may be formed without affecting the layout of the devices on the printed circuit board 20. The width of the heat-conductive mounting strip 30 generally does not exceed the board edge prohibition size of the printed circuit board.

In the embodiments of the present disclosure, a heat conductive layer 22 is provided on the surface of the device prohibition area of the printed circuit board 20, and the heat conductive layer 22 is connected to the ground layer copper sheet 23 in the printed circuit board 20 through a first heat dissipation via hole 24. In the embodiments of the present disclosure, the heat conductive layer 22 is a copper layer. In this way, the ground layer copper sheet 23 in the printed circuit board 20 may be connected to the bottom case 10 through the first heat dissipation via hole 24 and the heat conductive layer 22, thereby improving the heat dissipation performance of the printed circuit board 20.

In the embodiments of the present disclosure, the printed circuit board 20 is soldered with a component, and a second heat dissipation via hole 25 is provided at a welding part between the component and the printed circuit board 20. The component is connected to the ground layer copper sheet 23 in the printed circuit board 20 through the second heat dissipation via hole 25. The edge of the printed circuit board 20 connects the heat conductive layer 22 acting as a surface layer heat conductive contact surface with the inner ground layer copper sheet 23 through the first heat dissipation via hole 24, and the heat on the printed circuit board 20 is mainly diffused in a planar direction via the ground layer copper sheet 23 with a large area within the inner ground layer. In this way, the component, such as the QFN and TO package devices, on the printed circuit board 20 is connected to the ground layer copper sheet 23 by a via hole. The heat of such components may be spread and transferred to the edge of the printed circuit board 20, then is transferred to the heat-conductive mounting strip 30, and then is diffused to the bottom case 10 of the apparatus.

According to another embodiment of the present disclosure, there is provided a communication system including a cabinet and a communication apparatus installed in the cabinet, the communication apparatus being the above-described communication apparatus. The communication system has a perfect heat dissipation performance.

The embodiments of the present disclosure provide a small box-type communication apparatus as shown in Fig. 3. In the existing technical solution, the small box-type communication apparatus with natural heat dissipation is generally composed of a panel, a metal bottom case, an upper cover case with an aperture, a printed circuit board assembly and an auxiliary radiator, an interface panel and the like. The appearance of the small box-type communication apparatus is as shown in Fig. 2. A plurality of protruding riveted nuts are provided on the bottom case 1 of the apparatus, and mounting screw holes are arranged at corresponding positions of the printed circuit board 20. The printed circuit board 20 is supported by the protruding riveted nuts, and is then fixed to the bottom case 1 of the apparatus by means of mounting screws. The printed circuit board 20 is in point contact with the bottom case 1 of the apparatus, that is, only the screw holes are in contact with the riveted nuts of the bottom case 1 of the apparatus, and the remaining portion is suspended over the bottom case of the apparatus. In the embodiments of the present disclosure shown in Fig. 3, a heat-conductive mounting strip 30 is added between the bottom surface of the printed circuit board 20 and the metal bottom case 10 of the apparatus, so that a surface contact is formed between the heat-conductive mounting strip 30 and the printed circuit board 20 and the bottom case 10, thereby providing a good path for heat transfer.

In the embodiments of the present disclosure, the material of the heat-conductive mounting strip 30 is preferably aluminum, and the heat-conductive mounting strip 30 may be preferentially mounted on the bottom case 10 as an assembly of the bottom case 10 of the apparatus. An interface material for reducing a thermal contact resistance, such as a heat-conductive silicone grease, may be coated on a touch surface between the heat-conductive mounting strip 30 and the bottom case 10. The heat-conductive mounting strip 30 may also be preferentially mounted on the bottom surface of the printed circuit board 20 as an assembly of the printed circuit board 20, and then the entire printed circuit board assembly is installed to the bottom case of the apparatus.

On the basis of the foregoing embodiments, the edge of the printed circuit board 20 is coated with the copper sheet (heat conductive layer 22) on the surface according to the actual requirement. Fig. 7 shows a schematic diagram of coating the copper on a surface layer of the bottom surface at the edge of the printed circuit board 20 according to the embodiments of the present disclosure. The heat conductive layer 22 is brought into surface contact with the heat-conductive mounting strip 30 via the heat-conductive silicone grease.

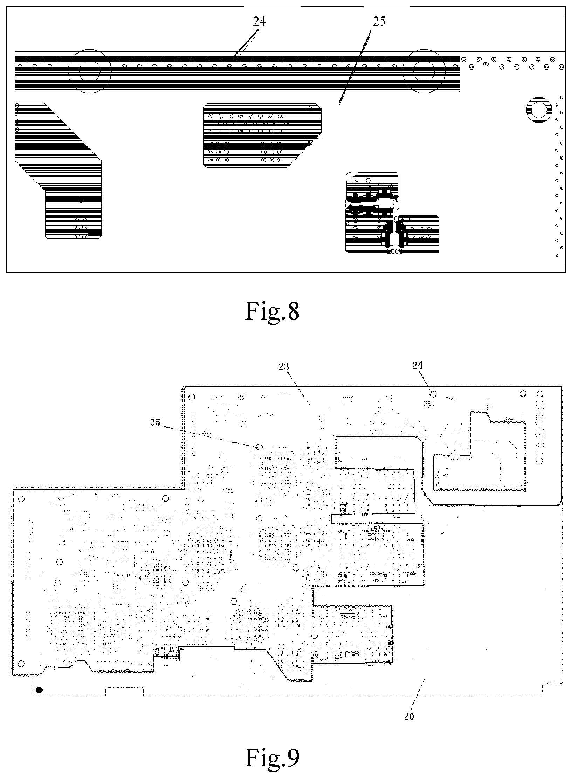

On the basis of the foregoing embodiments, a large number of heat via holes arc provided within a copper-coated area on the surface layer at the edge of the printed circuit board 20. Fig. 8 is a schematic diagram of the via holes (first heat dissipation via holes 24) within the copper-coated area at the edge of the printed circuit board 20 according to the embodiments of the present disclosure.

Since the material of the printed circuit board 20 is mainly composed of a copper (a ground layer copper sheet 23) having a good thermal conductivity and a FR4 having a poor thermal conductivity, the printed circuit board 20 is a layered-printed multilayer material and has a poor thermal conductivity between layers. The thermal conductivities within the layer plane differ according to an area and a range of the copper sheet. Therefore, the thermal conductivity of the printed circuit board in a thickness direction is generally much smaller than the thermal conductivity of the printed circuit board in a plane direction.

By adding the heat via holes, the ground layer copper sheets 23 between different layers of the printed circuit board 20 may be connected so as to improve the thermal conduction between the different layers in the thickness direction of the printed circuit board 20. The size of the first heat dissipation via hole 24 at the edge of the board is generally greater than that of a normal signal via hole, and preferably is 90 mil in outer diameter, and 50 mil in diameter, but it is not limited thereto.

On the basis of the foregoing embodiment, the ground layer of the printed circuit board 20 is covered with a large area of copper, while the ground layer copper sheet 23 extends to the edge of the printed circuit board 20, and is connected to the surface layer copper sheet 23 (the heat conductive layer 22) at the edge of the printed circuit board 20 through the first heat dissipation via hole 24. Fig. 9 shows an example of a ground layer copper sheet 23 of the printed circuit board 20 of the present disclosure. The ground layer copper sheet 23 extends to the edge area of the board, and such edge area of the board has the aforementioned surface layer copper sheet, the first heat dissipation via hole 24, and the heat-conductive mounting strip 30. Thus, the ground layer copper sheet 23 of the printed circuit board 20 is extended to the edge of the board, and is connected to the surface layer copper sheet at the edge of the printed circuit board 20 by the heat via hole at the edge of the board, and then is in surface contact with the heat-conductive mounting strip 30 by the heat-conductive grease, so as to form a heat flow path.

On the basis of the foregoing embodiments, the bottoms of some components (e.g., the QFN and TO packages) on the printed circuit board 20 have a heat dissipation pad. When the components are soldered on the printed circuit board, the heat of the components is conducted through the pad to the soldered copper sheet on the surface layer of the printed circuit board 20, and is then transferred to the ground layer copper sheet 23 of the printed circuit board 20 through the second heat dissipation via hole 25 on the printed circuit board 20. At this time, the components - the edge of the printed circuit board 20 - the heat-conductive mounting strip 30 - the bottom case 10 forms a complete heat transfer path.

From the above description, it can be seen that the above-described embodiments of the present disclosure have the following technical effects.

As can be seen from the above technical solutions, the communication apparatus of the present disclosure connects the edge of the printed circuit board with the bottom case through the heat-conductive mounting strip so that the point contact between the printed circuit board and the bottom case in the conventional technical solution becomes a surface contact. Thus, the path for conducting and diffusing heat from the printed circuit board to the bottom case is improved, and the heat dissipation capacity of the communication apparatus is improved.

## Claims

1. A communication apparatus, comprising: a bottom case (10) and a printed circuit board (20) mounted on the bottom case (10), the communication apparatus further comprising a heat-conductive mounting strip (30), the printed circuit board (20) being mounted on the bottom case (10) by means of the heat-conductive mounting strip (30), wherein a lower end surface of the heat-conductive mounting strip (30) is connected to the bottom case (10), and an upper end surface of the heat-conductive mounting strip (30) is connected to the printed circuit board (20),
wherein the printed circuit board (20) is welded with a component which generates heat, the printed circuit board (20) comprises a device arranging area and a device prohibition area which is provided around the device arranging area and located at an edge of the printed circuit board (20) and the heat-conductive mounting strip (30) is connected to the device prohibition area of the printed circuit board (20),
wherein a surface of the device prohibition area of the printed circuit board (20) is laid with a heat conductive layer (22), the heat conductive layer (22) is laid on the edge of the bottom of the printed circuit board (20) and is brought into surface contact with the heat-conductive mounting strip (30), and the heat conductive layer (22) is connected to a ground layer copper sheet (23) in the printed circuit board (20) through a first heat dissipation via hole (24), and wherein a welding part between the component and the printed circuit board (20) is provided with a second heat dissipation via hole (25), and the component is connected to the ground layer copper sheet (23) in the printed circuit board (20) through the second heat dissipation via hole (25),
**characterized in that** a recess (21) is provided on the printed circuit board (20), the heat-conductive mounting strip (30) comprises: a support portion (31) and a connecting portion (32), the printed circuit board (20) is supported on the support portion (31), and the connecting portion (32) passes through the recess (21) and then is connected with a radiator (40) on the printed circuit board (20), so that the heat-conductive mounting strip (30) provides surface contact with the bottom case (10) for both the printed circuit board (20) and the radiator (40) at the same time, wherein the radiator (40) is coupled to components which are mainly cooled by the radiator (40).

2. The communication apparatus of claim 1, wherein individual contact surfaces of the heat-conductive mounting strip (30), the printed circuit board (20), and the bottom case (10) are all coated with a heat-conductive filler material.

3. The communication apparatus of claim 2, wherein the heat-conductive filler material is a heat-conductive silicone grease.

4. The communication apparatus of claim 1, wherein the heat-conductive mounting strip (30) and the printed circuit board (20) are connected to the bottom case (10) by screws.

5. The communication apparatus of claim 1, wherein the communication apparatus comprises a plurality of the heat-conductive mounting strips (30), and the plurality of heat-conductive mounting strips (30) are provided in a circumferential direction of the printed circuit board (20).

6. A communication system, wherein the system comprises: a cabinet
and a communication apparatus installed in the cabinet, the communication apparatus being the communication apparatus of any of claims 1-5.

## Patentansprüche

1. Kommunikationsapparat, umfassend: ein Bodengehäuse (10) und eine gedruckte Leiterplatte (20), die am Bodengehäuse (10) montiert ist, wobei der Kommunikationsapparat ferner einen wärmeleitenden Montagesteg (30) umfasst, die gedruckte Leiterplatte (20) am Bodengehäuse (10) mittels des wärmeleitenden Montagestegs (30) montiert ist, worin eine untere Endfläche des wärmeleitenden Montagestegs (30) mit dem Bodengehäuse (10) verbunden ist, und eine obere Endfläche des wärmeleitenden Montagestegs (30) mit der gedruckten Leiterplatte (20) verbunden ist,
worin die gedruckte Leiterplatte (20) mit einer Komponente geschweißt ist, die Wärme erzeugt, die gedruckte Leiterplatte (20) einen Vorrichtungsanordnungsbereich und einen Vorrichtungsverbotsbereich, der um den Vorrichtungsanordnungsbereich vorgesehen und an einer Kante der gedruckten Leiterplatte (20) gelegen ist, umfasst, und der wärmeleitende Montagesteg (30) mit dem Vorrichtungsverbotsbereich der gedruckten Leiterplatte (20) verbunden ist,
worin eine Fläche des Vorrichtungsverbotsbereiches der gedruckten Leiterplatte (20) mit einer wärmeleitenden Schicht (22) belegt ist, die wärmeleitende Schicht (22) an der Kante des Bodens der gedruckten Leiterplatte (20) gelegt ist und mit dem wärmeleitenden Montagesteg (30) in Oberflächenkontakt gebracht ist, und die wärmeleitende Schicht (22) mit einem Grundschichtkupferblech (23) in der gedruckten Leiterplatte (20) durch ein erstes Wärmeabfuhrumlenkloch (24) verbunden ist, und worin ein Schweißteil zwischen der Komponente und der gedruckten Leiterplatte (20) mit einem zweiten Wärmeabfuhrumlenkloch (25) versehen ist, und die Komponente mit dem Grundschichtkupferblech (23) in der gedruckten Leiterplatte (20) durch das zweite Wärmeabfuhrumlenkloch (25) verbunden ist,
**dadurch gekennzeichnet, dass** eine Aussparung (21) an der gedruckten Leiterplatte (20) vorgesehen ist, der wärmeleitende Montagesteg (30) umfasst: einen Stützabschnitt (31) und einen Verbindungsabschnitt (32), die gedruckte Leiterplatte (20) auf dem Stützabschnitt (31) abgestützt ist, und der Verbindungsabschnitt (32) durch die Aussparung (21) läuft und dann mit einem Kühler (40) an der gedruckten Leiterplatte (20) verbunden ist, so dass der wärmeleitende Montagesteg (30) Oberflächenkontakt mit dem Bodengehäuse (10) sowohl für die gedruckte Leiterplatte (20) als auch für den Kühler (40) zur gleichen Zeit liefert, worin der Kühler (40) mit Komponenten gekoppelt ist, die hauptsächlich vom Kühler (40) gekühlt sind.

2. Kommunikationsapparat nach Anspruch 1, worin einzelne Kontaktflächen des wärmeleitenden Montagestegs (30), der gedruckten Leiterplatte (20) und des Bodengehäuses (10) alle mit einem wärmeleitenden Füllmaterial beschichtet sind.

3. Kommunikationsapparat nach Anspruch 2, worin das wärmeleitende Füllmaterial ein wärmeleitendes Silikonfett ist.

4. Kommunikationsapparat nach Anspruch 1, worin der wärmeleitende Montagesteg (30) und die gedruckte Leiterplatte (20) mit dem Bodengehäuse (10) durch Schrauben verbunden sind.

5. Kommunikationsapparat nach Anspruch 1, worin der Kommunikationsapparat eine Vielzahl der wärmeleitenden Montagestege (30) umfasst, und die Vielzahl der wärmeleitenden Montagestege (30) in einer Umfangsrichtung der gedruckten Leiterplatte (20) vorgesehen sind.

6. Kommunikationssystem, worin das System umfasst: einen Schrank und einen Kommunikationsapparat, der im Schrank installiert ist, wobei der Kommunikationsapparat der Kommunikationsapparat nach einem der Ansprüche 1-5 ist.

## Revendications

1. Appareil de communication, comprenant : un boîtier inférieur (10) et une carte de circuit imprimé (20) montée sur le boîtier inférieur (10), l'appareil de communication comprenant en outre une bande de montage thermoconductrice (30), la carte de circuit imprimé (20) étant montée sur le boîtier inférieur (10) au moyen de la bande de montage thermoconductrice (30), dans lequel une surface d'extrémité inférieure de la bande de montage thermoconductrice (30) est reliée au boîtier inférieur (10), et une surface d'extrémité supérieure de la bande de montage thermoconductrice (30) est reliée à la carte de circuit imprimé (20),
dans lequel la carte de circuit imprimé (20) est soudée avec un composant qui génère de la chaleur, la carte de circuit imprimé (20) comprend une zone de disposition de dispositif et une zone d'interdiction de dispositif qui est prévue autour de la zone de disposition de dispositif et située au niveau d'un bord de la carte de circuit imprimé (20) et la bande de montage thermoconductrice (30) est reliée à la zone d'interdiction de dispositif de la carte de circuit imprimé (20),
dans lequel une surface de la zone d'interdiction de dispositif de la carte de circuit imprimé (20) est posée avec une couche thermoconductrice (22), la couche thermoconductrice (22) est posée sur le bord du fond de la carte de circuit imprimé (20) et est amenée en contact de surface avec la bande de montage thermoconductrice (30), et la couche thermoconductrice (22) est reliée à une feuille de cuivre de couche de masse (23) dans la carte de circuit imprimé (20) par l'intermédiaire d'un premier trou d'interconnexion de dissipation thermique (24), et dans lequel une partie de soudage entre le composant et la carte de circuit imprimé (20) est pourvue d'un second trou d'interconnexion de dissipation thermique (25), et le composant est relié à la feuille de cuivre de couche de masse (23) dans la carte de circuit imprimé (20) par l'intermédiaire du second trou d'interconnexion de dissipation thermique (25), **caractérisé en ce qu'**un évidement (21) est prévu sur la carte de circuit imprimé (20), la bande de montage thermoconductrice (30) comprend : une partie de support (31) et une partie de connexion (32), la carte de circuit imprimé (20) est supportée sur la partie de support (31), et la partie de connexion (32) traverse l'évidement (21) puis est reliée à un radiateur (40) sur la carte de circuit imprimé (20), de sorte que la bande de montage thermoconductrice (30) assure un contact de surface avec le boîtier inférieur (10) à la fois pour la carte de circuit imprimé (20) et le radiateur (40), dans lequel le radiateur (40) est couplé à des composants qui sont principalement refroidis par le radiateur (40).

2. Appareil de communication selon la revendication 1, dans lequel les surfaces de contact individuelles de la bande de montage thermoconductrice (30), de la carte de circuit imprimé (20) et du boîtier inférieur (10) sont toutes revêtues d'un matériau de remplissage thermoconducteur.

3. Appareil de communication selon la revendication 2, dans lequel le matériau de remplissage thermoconducteur est une graisse de silicone thermoconductrice.

4. Appareil de communication selon la revendication 1, dans lequel la bande de montage thermoconductrice (30) et la carte de circuit imprimé (20) sont reliées au boîtier inférieur (10) par des vis.

5. Appareil de communication selon la revendication 1, dans lequel l'appareil de communication comprend une pluralité de bandes de montage thermoconductrices (30), et la pluralité de bandes de montage thermoconductrices (30) sont prévues dans une direction circonférentielle de la carte de circuit imprimé (20).

6. Système de communication, dans lequel le système comprend : un logement et un appareil de communication installé dans le logement, l'appareil de communication étant l'appareil de communication selon l'une quelconque des revendications 1 à 5.
